Europäisches Patentamt

European Patent Office

Office européen des brevets

(19)

(11) **EP 0 604 281 B1**

(12) **FASCICULE DE BREVET EUROPEEN**

(45) Date de publication et mention
de la délivrance du brevet:
**04.03.1998 Bulletin 1998/10**

(51) Int Cl.⁶: **H01L 29/768**, G11C 19/28

(21) Numéro de dépôt: **93403072.7**

(22) Date de dépôt: **17.12.1993**

(54) **Registre à décalage à transfert de charges avec dispositif de lecture amélioré**

CCD-Schieberegister mit verbesserter Ausleseanordnung

CCD shift register with improved read-out device

(84) Etats contractants désignés:
**AT DE FR GB IT NL**

(30) Priorité: **22.12.1992 FR 9215478**

(43) Date de publication de la demande:
**29.06.1994 Bulletin 1994/26**

(73) Titulaire: **THOMSON-CSF SEMICONDUCTEURS SPECIFIQUES**
**75008 Paris (FR)**

(72) Inventeurs:
• **Cazaux, Yvon**
**F-92402 Courbevoie Cedex (FR)**
• **Cortiula, Jean-Alain**
**F-92402 Courbevoie Cedex (FR)**

• **Marine, Jean**
**F-92402 Courbevoie Cedex (FR)**

(74) Mandataire: **Guérin, Michel et al**
**THOMSON-CSF-S.C.P.I.,**
**13, Avenue du Président**
**Salvador Allende**
**94117 Arcueil Cédex (FR)**

(56) Documents cités:
**EP-A- 0 242 291          EP-A- 0 456 241**

• **PATENT ABSTRACTS OF JAPAN vol. 11, no. 148 (E-506)14 Mai 1987 & JP-A-61 285 767 (NEC CORP)**
• **PATENT ABSTRACTS OF JAPAN vol. 8, no. 59 (E-232)17 Mars 1984 & JP-A-58 210 674 (SHARP KK)**

## Description

L'invention concerne les dispositifs à transfert de charges ou dispositifs CCD (de l'anglais "Charge Coupled Devices").

Un registre à décalage à transfert de charge est constitué par une succession d'électrodes juxtaposées au-dessus d'une zone semiconductrice superficielle ; les électrodes, sont en général isolées de cette zone par une couche isolante très mince.

L'application de potentiels convenables aux électrodes permet de créer dans le semiconducteur des puits de potentiel dans lesquels des charges électrique mobiles peuvent s'accumuler. Des modifications de potentiels appropriées permettent de déverser ces charges d'un puits vers un puits adjacent, et ceci en synchronisme pour tous les puits du registre, de manière à faire avancer en synchronisme des paquets de charge vers la sortie du registre. Les charges accumulées dans les puits sont introduites soit par une extrémité amont du registre, soit en parallèle dans tous les puits. Ces charges représentent des informations, telles que par exemple la luminance de chaque point d'une ligne d'image dans le cas d'un registre à décalage associé à un capteur d'image photosensible.

Les paquets de charges électriques transportés par le registre peuvent être convertis en tensions électriques à la sortie du registre ; ces tensions sont ensuite traitées par des circuits analogiques ou logiques. Pour cela, on place en sortie du registre un dispositif de conversion charge/tension, appelé encore dispositif de lecture de charges.

Le dispositif de lecture fonctionne en synchronisme avec le registre, de sorte que chaque paquet de charges qui atteint le dispositif de lecture peut être converti en une tension électrique, cette tension étant transmise vers un circuit aval (constitué le plus souvent par un échantillonneur bloqueur), avant qu'un nouveau paquet de charges parvienne au dispositif de lecture.

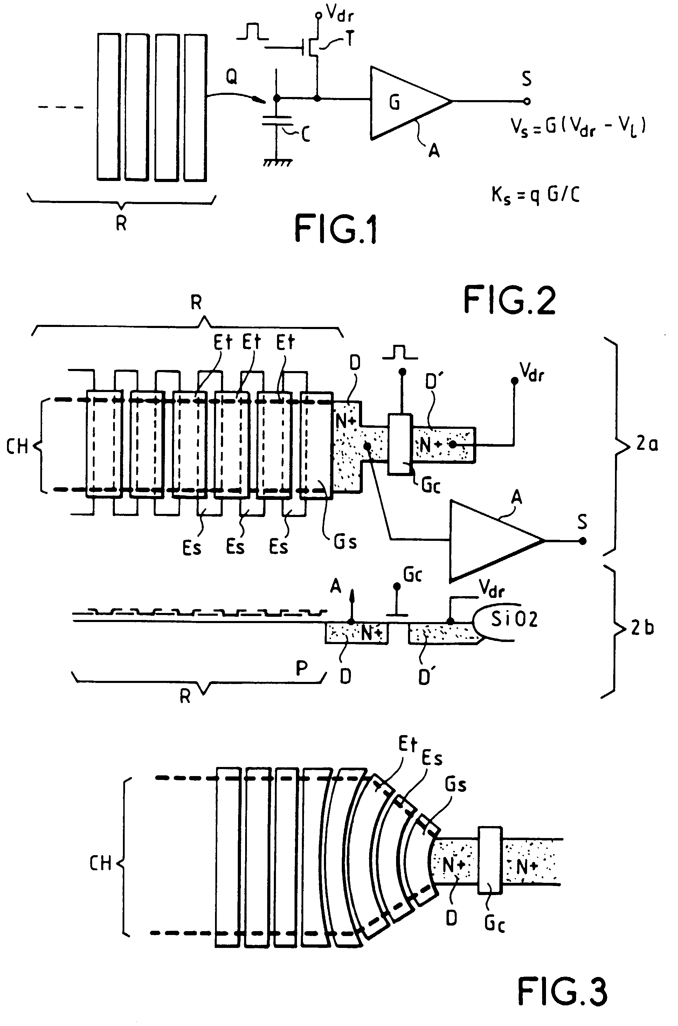

Le dispositif de lecture le plus simple, représenté sous forme symbolique à la figure 1, est constitué par :

- une capacité C ayant une électrode à potentiel fixe (la masse par exemple) et une électrode à potentiel variable,
- un transistor T pour précharger périodiquement la capacité à un autre potentiel fixe (Vdr),
- et un amplificateur A, à haute impédance d'entrée, relié à la capacité, pour détecter le potentiel aux bornes de celle-ci.

La tension de sortie Vs de l'amplificateur représente le signal de sortie du dispositif de lecture, proportionnel à la quantité de charges contenues dans le paquet lu.

Avant le début d'une opération de lecture, le transistor T est rendu conducteur, de sorte que l'électrode à potentiel variable, qui est reliée au transistor, est portée au potentiel fixe de précharge Vdr. Le potentiel de précharge Vdr est positif dans le cas habituel où les charges transportées sont négatives (électrons).

Puis, le transistor T est bloqué et un paquet de charges est déversé, par l'intermédiaire de la dernière électrode du registre R, sur l'électrode à potentiel variable de la capacité. Le potentiel de cette électrode, initialement à Vdr, chute d'une valeur Vl proportionnelle à la quantité de charges du paquet. La tension Vs = G (Vdr-Vl), apparaissant sur la sortie S de l'amplificateur A de gain G, est une fonction linéaire de la chute de tension Vl; cette chute de tension Vl est elle-même égale au rapport entre la quantité de charges Q déversée dans la capacité C et la valeur de cette capacité C :

$$Vl = Q/C$$

Le dispositif de lecture possède alors ce qu'on appelle un facteur de conversion Ks, égal à qG/C, où q est la charge de l'électron ; ce facteur de conversion représente la valeur de l'incrément de tension apparaissant en sortie S du dispositif (c'est-à-dire en sortie de l'amplificateur A) lorsqu'un incrément de charge (un électron) est déversé dans la capacité C.

Si on veut pouvoir lire des faibles quantités de charges, par exemple celles qui résultent d'un faible éclairement d'une photodiode, il est utile que le facteur de conversion Ks soit élevé. On peut obtenir ce résultat avec un gain G suffisamment élevé et une capacité C faible.

Mais les impératifs technologiques des dispositifs CCD font qu'en pratique l'amplificateur A est réalisé avec des transistors à effet de champ à grille isolée (MOS). Ces amplificateurs présentent un bruit important à l'entrée et ce bruit est amplifié avec le gain G. Il est donc souhaitable de ne pas avoir un gain trop important. On utilise même en pratique des amplificateurs suiveurs à gain inférieur à 1. C'est alors la valeur de la capacité C qu'il faut considérablement diminuer pour avoir un facteur de conversion Ks important.

Pour réaliser cette capacité, on utilise le plus souvent une diode à jonction PN polarisée en inverse. L'électrode portée à la masse est le substrat (en principe de type P) du semiconducteur dans lequel est formé le registre CCD, et l'autre électrode de la diode est constituée par une zone de type N$^+$ diffusée superficiellement dans le substrat et placée immédiatement à côté de la dernière électrode du registre, de manière qu'un paquet de charges circulant dans le registre puisse se déverser directement dans la zone diffusée N$^+$.

La figure 2 représente en vue de dessus (figure 2a) et en coupe longitudinale (figure 2b) le principe de réalisation d'un tel dispositif de lecture en sortie d'un registre. Le registre R comporte une alternance d'électrodes de stockage Es et d'électrodes de transfert Et. La dernière électrode de stockage est en général suivie d'une électrode de sortie Gs à potentiel fixe, qui elle-même est suivie de la diode de lecture D (diffusion N$^+$) et immédiatement adjacente à celle-ci. La diffusion N+ constitue en même temps la source du transistor de précharge et elle est donc séparée d'une autre diffusion N+ (D'), constituant le drain de ce transistor, par une grille de commande isolée Gc. Le drain D' est relié à une source de tension Vdr ; la diffusion N+ de la diode D est reliée par un contact électrique superficiel à l'entrée de l'amplificateur A ; l'amplificateur est représenté sous forme symbolique à la figure 2.

Sur la figure 2 on a représenté en pointillés gras les limites latérales du canal CH dans lequel circulent les charges sous les électrodes ; ce canal est défini par la zone semiconductrice surplombée par les électrodes du registre et séparée de ces électrodes par une couche isolante très mince; le canal CH peut être délimité latéralement par de l'oxyde de silicium épais sur lequel remontent les extrémités latérales des électrodes. La diffusion N+ de la diode D est dans le prolongement de ce canal et est elle-même entourée d'oxyde épais, de même que le drain D'. La coupe de la figure 2b est prise selon l'axe du canal CH et ne laisse donc pas apparaître l'oxyde de silicium épais qui entoure le canal; une zone d'oxyde épais a cependant été représentée au delà du drain D' du transistor.

Dans le cas de la figure 2, la diode de lecture D est adjacente à toute la largeur des électrodes du registre (20 à 100 micromètres de large par exemple). On ne peut donc guère considérer qu'elle a une petite surface, et le facteur de conversion du dispositif de lecture est assez faible.

C'est pourquoi on a déjà proposé dans l'art antérieur (voir par exemple EP 0242 291) un dispositif tel que celui de la figure 3, dans lequel la diode a effectivement une faible surface (par exemple 5 micromètres sur 5 micromètres); le canal CH où circulent les charges se rétrécit progressivement vers cette diode.

Pour améliorer le transfert, en uniformisant les trajets des charges, les électrodes sont en secteurs de couronne à proximité de la diode.

On a ainsi obtenu un compromis entre la nécessité d'une largeur suffisante du registre (pour transporter des quantités de charge importantes, correspondant par exemple à un éclairement intense d'une photodiode) et une petite taille de diode de lecture (pour pouvoir lire des faibles charges avec un rapport signal sur bruit correct).

On notera que dans le dispositif de la figure 3 les électrodes de stockage Es ont en principe une longueur L (dans le sens longitudinal, c'est-à-dire dans le sens de transfert des charges) progressivement croissante, afin de conserver une surface de stockage à peu près constante malgré la réduction progressive de la largeur du canal.

Pour des raisons qu'on tentera d'expliciter dans la suite, on s'est aperçu que la structure de la figure 3 présentait des inconvénients, justement dus au rétrécissement du canal.

On a également proposé, dans le brevet japonais JP 61 2 8 57 67 publié le 16 décembre 1986 une structure à électrodes toutes rectilignes et sans rétrécissement de canal, dans laquelle le canal déborde légèrement sur les bords latéraux de la diode de lecture. Ce document divulgue un dispositif correspondant au préambule de la revendication 1.

L'invention a pour but d'essayer de réduire les inconvénients des structures connues, tout en gardant l'avantage d'une petite capacité de lecture (c'est-à-dire l'avantage d'un facteur de conversion important sans détérioration excessive du rapport signal/bruit en signaux faibles).

Pour atteindre ce but, l'invention propose de faire en sorte que la largeur de la dernière grille du registre, adjacente à une diode de lecture de petite dimension, soit (par rapport à la surface de la diode de lecture) nettement plus grande que dans la technique antérieure. Le mot largeur est pris ici, comme dans toute la suite, comme étant une mesure de dimension selon une ligne qui est sensiblement perpendiculaire au trajet des charges électriques.

On propose pour cela un registre à décalage à transfert de charges formé dans un substrat semiconducteur et comportant un canal de transfert de charge CH et un dispositif de lecture de charges à une extrémité du canal, le dispositif de lecture comportant une grille de sortie Gs formant une électrode finale du registre à décalage, adjacente à une zone semiconductrice D diffusée dans le substrat et formant avec le substrat une jonction capacitive, caractérisée en ce que la zone diffusée comporte une surface principale et un prolongement étroit par rapport au reste de la zone diffusée en saillie depuis la surface principale vers le canal, ce prolongement étant entouré, sur ses côtés adjacents au canal, par la grille de sortie Gs.

Dans une première réalisation, l'invention propose un registre à décalage à transfert de charges formé dans un substrat semiconducteur, qui comporte une grille de sortie formant la dernière électrode du registre à décalage, adjacente à une zone semiconductrice diffusée formant avec le substrat une jonction capacitive, et qui est caractérisé en ce que la grille de sortie est adjacente à la zone diffusée sur une largeur d'au moins 40 % et de préférence plus de 50 % du périmètre de la zone diffusée.

Autrement dit : dans l'art antérieur la dernière grille est adjacente à la diode de lecture en générale le long d'au plus 25 à 30 % du périmètre de la diode (en tous cas dans le cas de diodes de lecture petites devant les surfaces des électrodes de stockage du registre, c'est-à-dire en général dans le cas où le canal de transfert de charges du registre va en se rétrécissant vers une diode plus petite que la largeur principale du canal); ici, on propose que la grille de sortie entoure si possible environ la moitié du périmètre de la diode, le plus possible étant le mieux.

Par prolongement étroit on entend un prolongement ayant une largeur plus petite que les dimensions de la surface principale. Ce prolongement a pour effet d'augmenter la longueur de grille adjacente à la diode à l'extrémité du canal.

La longueur de ce prolongement peut être du même ordre que les dimensions latérales de la surface principale de la zone diffusée, et de préférence elle est même plus grande. La largeur est de préférence d'au moins 2 à 3 fois plus faible que les dimensions latérales de la surface principale.

La surface principale peut on non être entourée par la grille de sortie.

On comprendra que l'invention propose plus généralement de configurer la zone diffusée et la grille de sortie qui l'entoure de telle manière que la largeur sur laquelle la grille est adjacente à la diode dans le canal de circulation de charges, c'est-à-dire encore la largeur sur laquelle l'extrémité du canal est adjacente à la diode, soit grande tout en conservant une surface de diode petite.

Ceci peut s'exprimer selon une autre définition de l'invention en disant que la grille de sortie est adjacente à la zone diffusée, à l'intérieur d'un canal de circulation de charges, sur une largeur qui est au moins 2 fois et de préférence au moins 2,5 fois, la racine carrée de la surface de la zone diffusée.

Ces différentes formulations de l'invention expriment l'idée commune qui est la suivante : il faut que malgré le rétrécissement de largeur du canal vers une diode de petite surface, on conserve une largeur de canal ou une largeur de dernière grille suffisamment élevée pour un bon transfert des charges du registre vers la diode.

L'invention permet notamment d'améliorer le comportement à haute fréquence du registre, les registres de l'art antérieur souffrant dans certains cas d'un mauvais transfert de charges à la sortie lorsque la fréquence de décalage du registre augmente. L'invention permet également d'améliorer le compromis entre un bon fonctionnement à haute fréquence, une bonne efficacité de transfert de charges vers le dispositif de lecture, et un faible signal résiduel pour un transfert de charges nul (signal d'obscurité dans le cas de dispositifs d'imagerie à transferts de charge : signal présent en sortie du dispositif de lecture même pour un transfert d'une quantité de charges nulle correspondant à un point d'image noir).

L'invention est applicable dans le cas où plusieurs registres à décalage aboutissent à une même diode de lecture : le dispositif de lecture fonctionnant soit à la même fréquence que les registres pour additionner dans la diode les charges venant des différents registres, soit à une fréquence multiple de celle des registres pour multiplexer dans le dispositif de lecture les signaux en provenance des différents registres. Dans les deux cas, la grille de sortie du registre, adjacente à la diode de lecture, peut être commune aux deux registres, et c'est la largeur cumulée des deux parties de cette grille qui est considérée comme "largeur de la dernière grille". En fait, le déversement de charges de chaque canal dans la diode ne se fera que sur la moitié de cette largeur; il est donc particulièrement important dans ce cas que le périmètre de déversement des charges dans la diode soit le plus grand possible; d'où l'importance encore accrue, dans ce cas particulier, d'utiliser les formes et dimensions de grille et de diode préconisées par l'invention.

D'autres caractéristiques et avantages de l'invention apparaîtront à la lecture de la description détaillée qui suit et qui est faite en référence aux dessins annexés dans lesquels :

- les figures 1 à 3 déjà décrites rappellent les principes connus de dispositifs de lecture de paquets de charge en sortie d'un registre CCD ;
- La figure 4 représente la structure générale du dispositif de lecture selon l'invention.
- La figure 5 représente une vue agrandie de la dernière grille du registre et de la diode.
- La figure 6 représente un double registre avec un dispositif de lecture commun;
- la figure 7 représente une réalisation pratique à l'échelle.

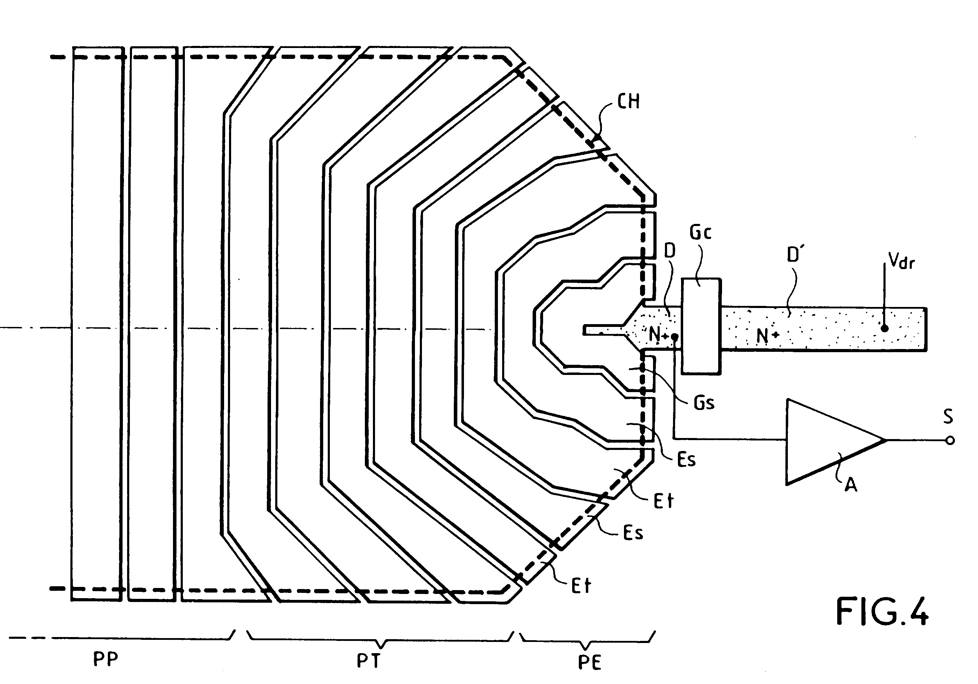

Le dispositif de lecture de la figure 4, placé à une extrémité d'un registre à décalage à transfert de charges peut être considéré comme comportant d'une part au moins la dernière électrode du registre, d'autre part la diode de lecture capacitive dans laquelle se déversent les charges, ainsi que les circuits associés (transistor de précharge T de la diode capacitive, amplificateur A). La dernière électrode Gs sera en général une électrode portée à un potentiel fixe contrairement aux autres électrodes du registre, dont les potentiels sont alternativement hauts et bas pour assurer le transfert des charges. La diode de lecture est de petite surface, c'est-à-dire de surface bien plus faible que celle des électrodes de stockage Es.

On remarque sur la figure 4 ce qui fait la spécificité de l'invention, à savoir la forme particulière de la zone diffusée $N^+$ constituant la diode de lecture D, et la forme de la dernière grille Gs du registre à décalage, adjacente à la diode D. La forme des autres grilles, précédant la grille Gs, se déduit de la grille Gs du fait qu'on souhaite passer progressivement de la forme rectangulaire allongée de la majeure partie des électrodes du registre à décalage à la forme spéciale de la grille Gs, en U évasé, à branches très rapprochées au fond du U.

La zone diffusé D de type $N^+$ possède une surface principale massive (c'est-à-dire par exemple assez carrée, donc de dimensions transversales de même ordre de grandeur dans toutes les directions) et une extension étroite dirigée de cette surface principale vers la grille de sortie Gs. En pratique l'extension étroite fait saillie dans l'axe de symétrie longitudinal du registre (axe horizontal au centre de la figure 4), pour un registre à symétrie axiale longitudinale.

La largeur de l'extension est de préférence nettement plus faible (2 à 3 fois par exemple) que les dimensions latérales de la partie massive de la zone semiconductrice D. La longueur de l'extension à partir de la partie massive peut être du même ordre que ces dimensions latérales.

A titre d'exemple : les dimensions latérales de la partie massive sont de 5x5 micromètres environ ; l'extension peut avoir une largeur de 1 à 2 micromètres et une longueur de 5μm en saillie vers la grille Gs. Dans l'exemple représenté, l'extension est reliée à la surface principale massive par une partie évasée qui facilite la diffusion dans la diode des charges qui sont déversées par le registre dans l'extension.

On rappelle que l'idée principale de l'invention est d'augmenter la portion de périmètre de diode de lecture qui est immédiatement adjacent à la dernière grille de sortie, c'est-à-dire la longueur de canal CH adjacente à la diode, sans augmenter sensiblement la surface globale de la zone diffusée. On a donc choisi cette forme avec extension étroite, mais d'autres formes peuvent être envisagées pourvu qu'elles augmentent suffisamment le rapport entre la portion de périmètre de diode adjacente à la grille Gs et la racine carrée de la surface de la diode. Un rapport d'au moins 2 à 2,5, et de préférence plus encore, est proposé selon l'invention, comme dans l'exemple représenté à la figure 4.

La portion d'extension étroite de la diode D est de toutes façons totalement entourée par la grille Gs ; la portion de surface massive peut être entourée de manière plus ou moins importante par la grille Gs, ou, plus exceptionnellement, elle peut ne pas être entourée du tout.

Le canal de transfert de charges CH a de préférence, vers son extrémité située du côté du dispositif de lecture, une forme allant en se rétrécissant progressivement puis tronquée à son extrémité sur une largeur beaucoup plus importante que la largeur de la diode, et c'est ce qui donne aux quelques électrodes d'extrémité une forme en U dont les branches se terminent sensiblement le long d'une ligne perpendiculaire à l'axe longitudinal du registre.

L'extrémité du canal pourrait être arrondie vers la diode. Sur la figure les bords du canal CH rejoignent les bords de la zone diffusée D le long d'une ligne perpendiculaire à un axe de symétrie général du canal.

On rappelle que le canal CH (défini par les traits pointillés épais sur la figure 4) est défini par les zones recouvertes d'isolant mince, sous les électrodes du registre, par opposition aux zones recouvertes d'isolant épais qui entourent le canal, la zone diffusée D, et le transistor de précharge (D, Gc, D').

La forme de la dernière grille Gs, sensiblement en U à branches très rapprochées autour de l'extension étroite de la diode , se transforme, pour les autres électrodes du registre, en U de plus en plus ouverts au fur et à mesure qu'on s'éloigne de la dernière grille.

Sur la figure 4 on a représenté par commodité des électrodes adjacentes séparées par un intervalle étroit, mais, dans la réalité, les grilles adjacentes se recouvrent légèrement.

Le transistor de précharge est constitué classiquement par exemple par une simple grille de commande Gc, éloignée de quelques micromètres des extrémités d'électrodes du registre. Cette grille sépare la zone diffusée $N^+$ D d'une zone diffusée D', également de type $N^+$, constituant le drain du transistor.

Le drain est relié à la source de tension de précharge Vdr. La diode D est reliée, par un contact superficiel, à un amplificateur A à haute impédance d'entrée. La sortie de l'amplificateur fournit périodiquement une tension représentant un paquet de charges déversé du registre dans la zone diffusée D.

Comme on le voit sur la figure 4, les électrodes du registre ont une forme rectangulaire allongée dans la partie principale (zone PP) du registre et une forme en U à l'extrémité (zone PE) du registre. Dans une zone intermédiaire de transition (zone PT) elles ont donc une forme qui varie progressivement, avec les contraintes suivantes :

- les électrodes doivent être si possible transversales par rapport à la direction de transfert de charges ; au centre du dispositif, la direction de transfert est l'axe longitudinal du dispositif ; mais sur les bords, la direction de transfert suit les bords obliques du canal ; à l'extrémité, là où le canal est tronqué perpendiculairement à l'axe longitudinal général, le transfert dans certaines zones du canal est même presque perpendiculaire à l'axe longitudinal du registre;

- les électrodes ne doivent pas avoir de zones exagérément longues (la longueur est prise dans le sens du transfert de charges) sur les bords par rapport à la longueur au centre du dispositif ; une trop grande longueur réduit l'efficacité de transfert de charges.

- la surface des électrodes de stockage doit être à peu près constante d'un bout à l'autre du registre, y compris dans les zones PT et PE, pour que l'aptitude au stockage de paquets de charge importants ne soit pas réduite à certains endroits du registre à cause d'une surface d'électrode trop faible. La grille de sortie Gs n'est pas concernée par cette nécessité car elle n'est pas une électrode de stockage.

Ces contraintes expliquent les formes d'électrodes successives telles que par exemple celles qu'on voit à la figure 4.

La figure 5 représente à nouveau l'ensemble de la dernière grille Gs du registre et de la diode D. La limite du canal CH (traits pointillés épais) est perpendiculaire à l'axe de symétrie longitudinal général. On a indiqué trois lignes pointillées fines représentant respectivement :

- la longueur moyenne L (dans le sens de transfert des paquets de charge d'une électrode de stockage Es vers la diode D);

- la largeur moyenne W de l'électrode (selon une ligne brisée sensiblement transversale en ses divers points aux trajets de paquets de charge);
- la largeur Ws sur laquelle la dernière grille Gs est adjacente à la diode D, ou encore sur laquelle le canal CH est adjacent à la diode D.

Le périmètre de la diode D est constitué en partie par cette largeur Ws et en partie par la longueur de ligne fermée désignée par Pe sur la figure. La surface de la diode est constituée par la surface à l'intérieur de ce périmètre.

Le fait que la grille de sortie Gs soit adjacente à la diode sur une partie importante du périmètre de la diode, ou encore le fait que la diode soit conformée avec une extension étroite vers la grille Gs, entraînent que le rapport W/L est beaucoup plus grand que dans les techniques utilisées antérieurement avec des registres à très petites diodes.

Cette augmentation du rapport W/L a les conséquences suivantes :

- l'efficacité de transfert de charges vers la diode est meilleure, surtout pour les fréquences de travail élevées, car le courant de transfert est sensiblement proportionnel à W/L.
- on n'est donc pas obligé de réduire exagérément la longueur L pour conserver un rapport W/L suffisant. Par conséquent on évite que la grille Gs soit trop courte (L petit), ce qui provoquerait un couplage entre la dernière électrode de stockage et la diode de lecture. Ce couplage se traduit par une erreur de lecture et il est d'autant plus fort que le substrat de silicium est de plus forte résistivité.
- comme les électrodes de la zone de transition PT se rapprochent de la forme en U de la grille de sortie, elles peuvent également toutes avoir un rapport W/L suffisant sans accroissement exagéré de leur longueur L ; on rappelle que les électrodes de stockage doivent avoir une surface sensiblement constante d'un bout à l'autre du registre.
- enfin, on évite un phénomène qu'on a constaté dans les registres à canal fortement rétréci : lorsque la dernière grille a une largeur qui se rétrécit (c'est-à-dire qu'elle est nettement moins large à la sortie de la grille qu'à l'entrée) et lorsque la largeur Ws en sortie est très faible (par exemple au-dessous de 10 micromètres dans la technologie habituelle du Demandeur), on constate une décroissance du potentiel sous la grille entre l'entrée et la sortie de la grille, entraînant une rétention indésirable de charges sous la grille. La forme de la grille de sortie selon l'invention évite ce problème, car elle conserve une grille de largeur Ws suffisante à la sortie, malgré la petite surface de la diode.

L'invention s'applique également lorsque le dispositif de lecture est commun à deux registres juxtaposés, que ce soit pour une addition de paquets issus des deux registres ou pour un multiplexage des paquets de charge.

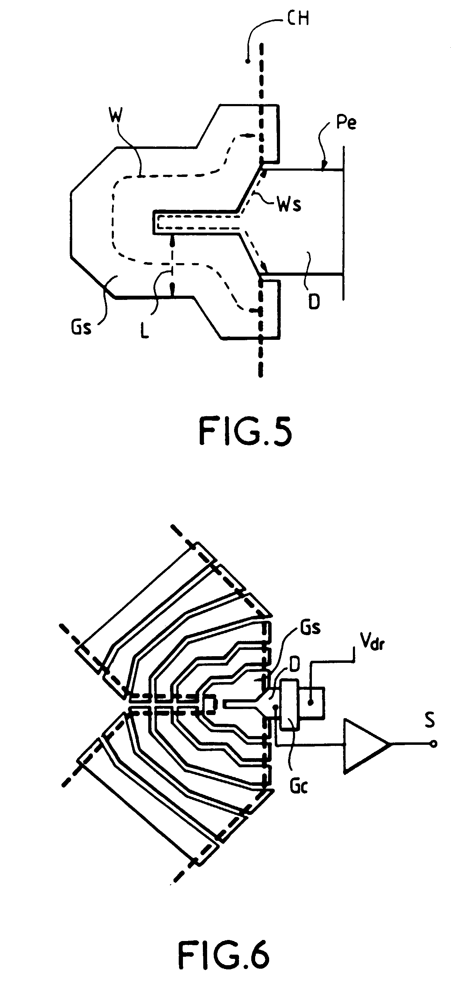

La figure 6 représente ce cas : les parties terminales des deux registres sont juxtaposés, leurs électrodes étant séparées (en tout cas au moins en ce qui concerne les électrodes de stockage). La dernière grille Gs n'est pas nécessairement coupée en deux. Sa forme globale est analogue à celle de la figure 4.

Si les registres sont actionnés simultanément, la diode de lecture additionne les paquets de charge. S'ils sont actionnés en opposition de phase, elle agit comme multiplexeur de paquets de charge, mais bien entendu la fréquence de travail du dispositif de lecture doit alors être double de celle des registres pour qu'une précharge de la diode soit effectuée avant chaque arrivée d'un paquet de charge. Les canaux des deux registres sont séparés jusqu'à la dernière grille Gs.

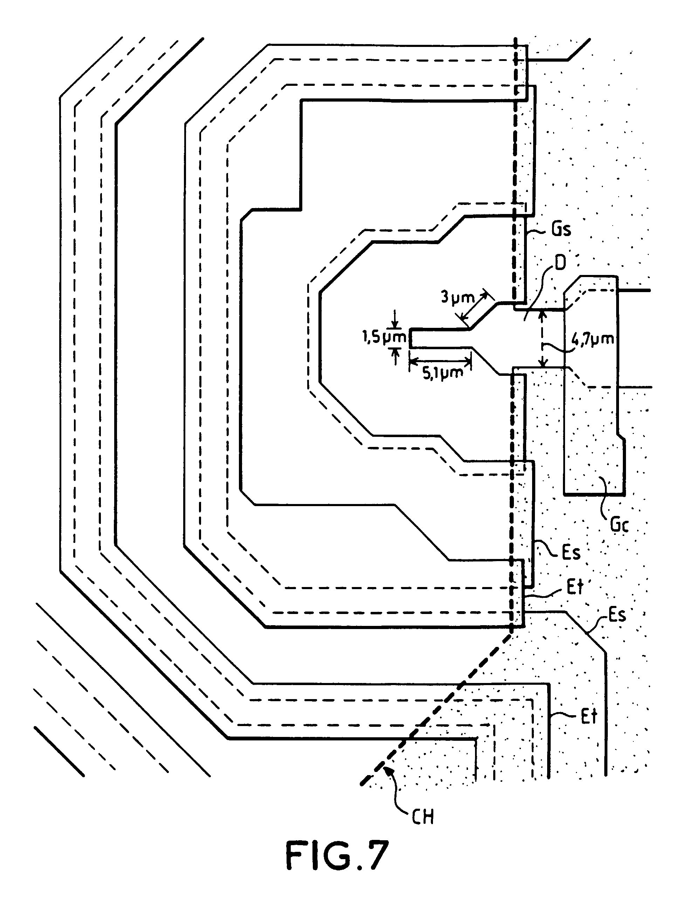

Pour terminer cette description, la figure 7 représente une réalisation expérimentale concrète de la Demanderesse, à l'échelle. Les différentes électrodes sont réalisées en trois niveaux de silicium polycristallin; premier niveau pour Gs, deuxième niveau pour les électrodes de stockage Es, troisième niveau pour les électrodes de transfert Et. Les zones d'oxyde épais sont représentées piquées de points, même là où elles sont recouvertes par les extrémités des différentes électrodes Et, Es, Gc, Gs. Dans cette réalisation pratique, on peut évaluer le périmètre total de la diode à environ 36 micromètres, la surface à 45 micromètres carrés; le périmètre de la diode à l'intérieur du canal à 20 micromètres (55% du périmètre total et 3 fois la racine carrée de la surface); la surface principale de la diode est d'environ 33 micromètres carrés avec des dimensions latérales d'environ 4 à 5 micromètres; l'extension étroite en saillie vers la grille Gs a une largeur d'environ 1,5 micromètre et une longueur d'environ 5 micromètres.

## Revendications

1. Registre à décalage à transfert de charges formé dans un substrat semiconducteur et comportant un canal de transfert de charges (CH) et un dispositif de lecture de charges à une extrémité du canal, le dispositif de lecture comportant une grille de sortie (Gs) formant une électrode finale du registre à décalage, adjacente à une zone semiconductrice (D) diffusée dans le substrat et formant avec le substrat une jonction capacitive, caractérisé en ce que la zone diffusée comporte une surface principale et un prolongement étroit par rapport au reste de la zone diffusée en saillie depuis la surface principale vers le canal, ce prolongement étant entouré, sur ses côtés adjacents au canal, par la grille de sortie (Gs).

2. Registre à décalage à transfert de charges selon la revendication 1, caractérisé en ce que la surface de la zone diffusée est très inférieure à la surface des électrodes de stockage (Es) du registre.

3. Registre à décalage à transfert de charges selon l'une des revendication 1 et 2, caractérisé en ce que le canal a une largeur qui va en se rétrécissant jusqu'à une extrémité du canal, la largeur du canal à cette extrémité restant largement supérieure à celle de la surface principale de la zone diffusée (D).

4. Registre à décalage à transfert de charges selon l'une des revendications 1 et 2, caractérisé en ce que les bords du canal rejoignent la zone diffusée sensiblement perpendiculairement à un axe de symétrie général du canal.

5. Registre à décalage à transfert de charges selon l'une des revendications 1 et 2, caractérisé en ce qu'il est constitué en deux registres à décalage juxtaposés avec deux canaux de transfert de charge séparés jusqu'à la grille de sortie Gs aboutissant à un dispositif de lecture de charges commun, un côté du prolongement étant adjacent à l'un des canaux et un autre côté étant adjacent à l'autre canal.

6. Registre à décalage à transfert de charges selon l'une des revendications 1 à 5, caractérisé en ce que la grille de sortie (Gs) est adjacente à la zone diffusée sur une largeur (Ws) d'au moins 40 % du périmètre de la zone diffusée (D).

7. Registre à décalage à transfert de charges selon l'une des revendication 1 à 6, caractérisé en ce que la grille de sortie (Gs) est adjacente à la zone diffusée à l'intérieur d'un canal (CH) de circulation de charges, sur une largeur qui est au moins de 2 fois la racine carrée de la surface de la zone diffusée.

8. Registre à décalage à transfert de charge selon l'une des revendications 1 à 7, caractérisé en ce que la dernière grille de sortie a une forme en U évasé.

## Claims

1. CCD shift register which is formed in a semiconductor substrate and comprises a charge-transfer channel (CH) and a charge read device at one end of the channel, the read device comprising an output gate (Gs) forming a final electrode of the shift register, adjacent to a semiconductor zone (D) diffused in the substrate and forming a capacitive junction with the substrate, characterized in that the diffused zone comprises a main surface and an extension which is narrow compared to the rest of the diffused zone and projects from the main surface towards the channel, this extension being surrounded, on its sides adjacent to the channel, by the output gate (Gs).

2. CCD shift register according to Claim 1, characterized in that the surface area of the diffused zone is very much less than the surface area of the storage electrodes (Es) of the register.

3. CCD shift register according to either of Claims 1 and 2, characterized in that the channel has a width which progressively narrows towards one end of the channel, the width of the channel at this end remaining substantially greater than that of the main surface of the diffused zone (D).

4. CCD shift register according to either of Claims 1 and 2, characterized in that the edges of the channel join the diffused zone substantially perpendicularly to a general symmetry axis of the channel.

5. CCD shift register according to either of Claims 1 and 2, characterized in that it consists of two shift registers juxtaposed with two charge-transfer channels which are separated as far as the output gate Gs terminating in a common charge read device, one side of the extension being adjacent to one of the channels and another side being adjacent to the other channel.

6. CCD shift register according to one of Claims 1 to 5, characterized in that the output gate (Gs) is adjacent to the diffused zone over a width (Ws) of at least 40% of the perimeter of the diffused zone (D).

7. CCD shift register according to one of Claims 1 to 6, characterized in that the output gate (Gs) is adjacent to the diffused zone inside a charge flow channel (CH), over a width which is at least twice the square root of the surface area of the diffused zone.

8. CCD shift register according to one of Claims 1 to 7, characterized in that the final output gate is in the form of a flared U.

## Patentansprüche

1. Ladungsübertragungs-Schieberegister, das in einem Halbleitersubstrat gebildet ist und einen Ladungsübertragungskanal (CH) und eine Ladungsleseeinrichtung an einem Ende des Kanals aufweist, wobei die Leseeinrichtung ein Ausgangsgate (Gs) enthält, das eine Endelektrode des Schieberegisters bildet, die an eine Halbleiterzone (D) angrenzt, die in das Substrat diffundiert ist und mit dem Substrat einen kapazitiven Übergang bildet, dadurch gekennzeichnet, daß die diffundierte Zone eine Hauptfläche und eine im Verhältnis zu dem Rest der diffundierten Zone schmale Verlängerung aufweist, die von der Hauptfläche zu dem Kanal vorspringt, wobei diese Verlängerung an ihren an den Kanal angrenzenden Seiten von dem Ausgangsgate (Gs) umgeben ist.

2. Ladungsübertragungs-Schieberegister nach Anspruch 1, dadurch gekennzeichnet, daß die Fläche der diffundierten Zone sehr viel kleiner als die Fläche der Speicherelektroden (Es) des Registers ist.

3. Ladungsübertragungs-Schieberegister nach einem der Ansprüche 1 und 2, dadurch gekennzeichnet, daß der Kanal eine Breite hat, die sich bis zu einem Ende des Kanals hin verengt, wobei die Breite des Kanals an diesem Ende weit größer als diejenige der Hauptfläche der diffundierten Zone (D) bleibt.

4. Ladungsübertragungs-Schieberegister nach einem der Ansprüche 1 und 2, dadurch gekennzeichnet, daß die Ränder des Kanals sich an die diffundierte Zone im wesentlichen senkrecht zu einer allgemeinen Symmetrieachse des Kanals anschließen.

5. Ladungsübertragungs-Schieberegister nach einem der Ansprüche 1 und 2, dadurch gekennzeichnet, daß es aus zwei nebeneinanderliegenden Schieberegistern mit zwei bis zum Ausgangsgate (Gs) getrennten Ladungsübertragungskanälen besteht, die an einer gemeinsamen Ladungsleseeinrichtung enden, wobei eine Seite der Verlängerung an einen der Kanäle und die andere Seite an den anderen Kanal angrenzt.

6. Ladungsübertragungs-Schieberegister nach einem der Ansprüche 1 bis 5, dadurch gekennzeichnet, daß das Ausgangsgate (Gs) an die diffundierte Zone über eine Weite (Ws) angrenzt, die wenigstens 40% des Umfangs der diffundierten Zone (D) beträgt.

7. Ladungsübertragungs-Schieberegister nach einem der Ansprüche 1 bis 6, dadurch gekennzeichnet, daß das Ausgangsgate (Gs) an die diffundierte Zone im Innern eines Ladungsumlaufkanals (CH) über eine Weite angrenzt, die wenigstens das Zweifache der Quadratwurzel der Fläche der diffundierten Zone beträgt.

8. Ladungsübertragungs-Schieberegister nach einem der Ansprüche 1 bis 7, dadurch gekennzeichnet, daß das letzte Ausgangsgate die Form eines sich erweiternden U hat.

FIG.1

$V_s = G (V_{dr} - V_L)$

$K_s = q \, G/C$

FIG.2

FIG.3

FIG.4

FIG.5

FIG.6

Gs

D

3 µm

1,5 µm

4,7 µm

5,1 µm

Gc

Es

Et

Es

Et

CH

FIG.7